# EUROPEAN PATENT APPLICATION

(11) **EP 4 518 595 A1**
(43) Date of publication of application: **05.03.2025**
(21) Application number: 23795449.0
(22) Date of filing: 26.04.2023
(51) Int. Cl.: H05K 7/14, H05K 7/18, H05K 5/02, H01M 50/244, H01R 13/631

(54) **ELECTRICAL DEVICE, ELECTRICAL SYSTEM, AND BATTERY PACK**

(30) Priority: 28.04.2022 CN 202210457481; 24.03.2023 CN 202310296626
(71) Applicant: Positec Power Tools (Suzhou) Co., Ltd., Suzhou, Jiangsu 215123 (CN)
(72) Inventor: WU, Hongbing, Suzhou, Jiangsu 215123 (CN); ZHOU, Yi, Suzhou, Jiangsu 215123 (CN); WU, Jie, Suzhou, Jiangsu 215123 (CN); CHEN, Mengxian, Suzhou, Jiangsu 215123 (CN)
(74) Representative: Kilburn & Strode LLP
(86) International application number: PCT/CN2023/090748
(87) International publication number: WO 2023/208017

(57) **Abstract**

The present invention relates to an electrical device, including: a device housing; and a battery pack mounting portion, arranged on the device housing and configured to detachably engage with a first battery pack or a second battery pack, where the battery pack mounting portion includes a pair of first guiding portions and a pair of second guiding portions, the first guiding portions are configured to guide the first battery pack to engage with the electrical device in an engaging direction, the second guiding portions are configured to guide the second battery pack to engage with the electrical device in the engaging direction, the first guiding portions and the second guiding portions are independent of each other, and in a width direction perpendicular to the engaging direction, the pair of first guiding portions are located on two sides of the pair of second guiding portions. In this way, the electrical device can adapt to battery packs with different interface sizes, to facilitate universalization and miniaturization of the electrical device. The present invention further provides an electrical system and a battery pack.

## Description

This application claims priority to Chinese Patent Application No. 202210457481.3, filed on April 28, 2022 and Chinese Patent Application No. 202310296626.0, filed on March 24, 2023, which are incorporated herein by reference in their entireties.

### TECHNICAL FIELD

The present invention relates to an electrical device, an electrical system, and a battery pack.

### BACKGROUND

In the related art, an electrical device can generally match a battery pack only with a fixed interface size, and a battery pack can generally also match an electrical device only with a fixed interface size. This is not conducive to universal use of the electrical device or the battery pack.

In another case, two interfaces with different sizes are arranged on a housing of an electrical device or a battery pack, and the two interfaces are separately and independently arranged in different regions. This makes the interface size of the electrical device or the battery pack large, resulting in a large volume of the electrical device or the battery pack, which is not conducive to miniaturization of the electrical device or the battery pack.

### SUMMARY

To overcome the disadvantages of the related art, the present invention provides an electrical device that can adapt to battery packs of different interface sizes and facilitate universalization and miniaturization.

A technical solution adopted in the present invention to solve the existing technical problems is as follows:
An electrical device includes: a device housing; and a battery pack mounting portion, arranged on the device housing and configured to detachably engage with a first battery pack or a second battery pack, the battery pack mounting portion including a pair of first guiding portions and a pair of second guiding portions, where the first guiding portions are configured to guide the first battery pack to engage with the electrical device in an engaging direction, the second guiding portions are configured to guide the second battery pack to engage with the electrical device in the engaging direction, the first guiding portions and the second guiding portions are independent of each other, and in a width direction perpendicular to the engaging direction, the pair of first guiding portions are located on two sides of the pair of second guiding portions.

The battery pack mounting portion includes the first guiding portions and the second guiding portions, and the first guiding portions and the second guiding portions are independent of each other, so that the electrical device can match battery packs with different interface sizes, to facilitate universalization and miniaturization of the electrical device.

Optionally, the first guiding portion and the second guiding portion at least partially overlap in the engaging direction.

Optionally, in the engaging direction, the second guiding portion does not exceed a region range defined by the first guiding portion.

Optionally, in the engaging direction, a ratio of a length of the first guiding portion to a length of the second guiding portion ranges from 1.5 to 2.

Optionally, in the width direction, a ratio of a maximum distance between the pair of first guiding portions to a maximum distance between the pair of second guiding portions ranges from 1.5 to 2.5.

Optionally, the pair of first guiding portions are arranged back to back, and the pair of second guiding portions are arranged face to face.

Optionally, the battery pack mounting portion further comprises a first support portion and a second support portion that extend in the engaging direction, the pair of first guiding portions comprise a pair of first extension portions that extend in the engaging direction, the pair of second guiding portions comprise a pair of second extension portions that extend in the engaging direction, the pair of first extension portions respectively protrude from outer sides of the first support portion and the second support portion in the width direction, and the pair of second extension portions respectively protrude from inner sides of the first support portion and the second support portion in the width direction.

Optionally, a ratio of energy of the first battery pack to an area of an engaging region defined by the pair of first guiding portions is defined as a first energy loading ratio, a ratio of energy of the second battery pack to an area of an engaging region defined by the pair of second guiding portions is defined as a second energy loading ratio, the first energy loading ratio is in a range of 2.05 to 5.58 Wh/cm², and/or the second energy loading ratio is in a range of 1.20 to 7.20 Wh/cm².

Optionally, in the engaging direction, a size of the second guiding portion is less than a size of the first guiding portion, each of the first guiding portion and the second guiding portion has an engaging beginning end and an engaging tail end that are oppositely arranged in the engaging direction, both the first battery pack and the second battery pack come, when engaging with the electrical device, into contact with the engaging beginning end earlier than the engaging tail end, and the engaging tail end of the second guiding portion is closer to the engaging beginning end of the first guiding portion than the engaging tail end of the first guiding portion.

Optionally, the battery pack mounting portion further comprises a plurality of device terminals located between the pair of second guiding portions, and the device terminals comprise a positive device terminal and a negative device terminal; when the first battery pack engages with the electrical device, the positive device terminal and the negative device terminal are configured to be electrically connected to corresponding terminals of the first battery pack, to implement power transmission between the first battery pack and the electrical device; and when the second battery pack engages with the electrical device, the positive device terminal and the negative device terminal are configured to be electrically connected to corresponding terminals of the second battery pack, to implement power transmission between the second battery pack and the electrical device.

Optionally, the battery pack mounting portion further comprises a locking member located between the pair of second guiding portions, and when the first battery pack engages with the electrical device, the locking member is configured to engage with a corresponding locking portion of the first battery pack, to lock the first battery pack to the electrical device; and when the second battery pack engages with the electrical device, the locking member is configured to engage with a corresponding locking portion of the second battery pack, to lock the second battery pack to the electrical device.

Optionally, the electrical device further comprises a device air vent located between the pair of second guiding portions, and when the first battery pack engages with the electrical device, air flow is flowable into and/or out from the device air vent, to cool the first battery pack and/or the electrical device; and when the second battery pack engages with the electrical device, air flow is flowable into and/or out from the device air vent, to cool the second battery pack and/or the electrical device.

Optionally, the electrical device is configured as any one of a charger, a back-carrying apparatus, a power tool, and a household appliance.

The present invention further provides an electrical system, including the foregoing electrical device, a first battery pack, and a second battery pack.

In this electrical system, the electrical device can adapt to the first battery pack and the second battery pack, thereby achieving universality of the electrical system and miniaturization of the electrical system.

The present invention further provides a battery pack, including a battery pack housing, an electrical device mounting portion is arranged on the battery pack housing, and the electrical device mounting portion is configured to detachably engage with a first electrical device or a second electrical device, where the electrical device mounting portion includes a pair of first leading portions and a pair of second leading portions, the pair of first leading portions are configured to guide the battery pack to engage with the first electrical device in an engaging direction, the pair of second leading portions are configured to guide the battery pack to engage with the second electrical device in the engaging direction, and projection regions of the pair of first leading portions and the pair of second leading portions on a plane perpendicular to a width direction at least partially overlap.

The electrical device mounting portion includes the first leading portions and the second leading portions, and the first leading portions and the second leading portions are independent of each other, so that the battery pack can match electrical devices with different interface sizes, to facilitate universalization and miniaturization of the battery pack.

### BRIEF DESCRIPTION OF THE DRAWINGS

The foregoing objects, technical solutions, and beneficial effects of the present invention can be implemented with reference to the accompanying drawings below:
FIG. 1 is a schematic diagram in which an electrical device according to the present invention is configured as a charger.
FIG. 2 is a front view of the electrical device shown in FIG. 1.
FIG. 3 is a schematic diagram of the electrical device shown in FIG. 1 engaging with a first battery pack.
FIG. 4 is a schematic diagram of a first battery pack.
FIG. 5 is a schematic diagram of the electrical device shown in FIG. 1 engaging with a second battery pack.
FIG. 6 is a schematic diagram of a second battery pack.
FIG. 7 is a schematic diagram in which an electrical device according to the present invention is configured as a back rack.
FIG. 8 is a schematic top view of a cross-sectional structure in which a first battery pack engages with the electrical device shown in FIG. 7 in a direction A-A in FIG. 7.
FIG. 9 is a schematic top view of a cross-sectional structure in which a second battery pack engages with the electrical device shown in FIG. 7 in a direction A-A in FIG. 7.
FIG. 10 is a schematic diagram in which an electrical device according to the present invention is configured as a lawn mower.
FIG. 11 is a schematic diagram of a battery pack according to the present invention.

### DETAILED DESCRIPTION

This application is described in detail below with reference with the embodiments shown in the accompanying drawings. However, these embodiments do not limit this application, and structural, methodological, or functional transformations made by a person of ordinary skill in the art according to these embodiments are included in the protection scope of this application.

It should be noted that when a component is referred to as "being fixed to" another component, the component may be directly on the other component, or an intervening component may be present. When a component is considered to be "connected to" another component, the component may be directly connected to the another component, or an intervening component may also be present. In the shown embodiments, direction representations, that is, upper, lower, left, right, front, and rear, are relative, and are used to explain that structures and movements of different components in this application are relative. These representations are appropriate when the components are at the positions shown in the drawings. However, if descriptions of component positions are changed, it is considered that the representations are also changed correspondingly.

Unless otherwise defined, meanings of all technical and scientific terms used in this specification are the same as those usually understood by a person skilled in the art to which this application belongs. In this application, terms used in the specification of this application are merely intended to describe objectives of the specific embodiments, but are not intended to limit this application. The term "and/or" used in this specification includes any and all combinations of one or more related listed items.

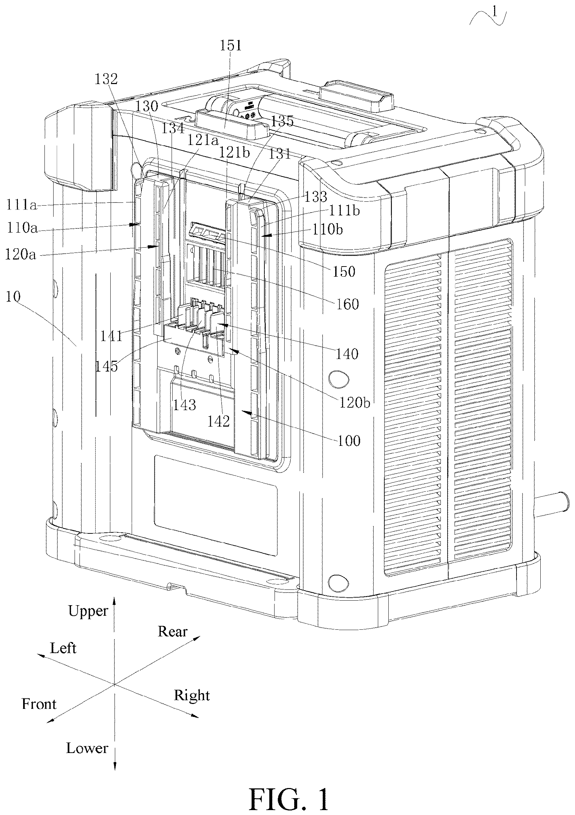

Referring to FIG. 1 to FIG. 6, some embodiments of the present invention provide an electrical system, the electrical system includes an electrical device 1, a first battery pack 2, and a second battery pack 3.

In some embodiments, as shown in FIG. 1, the electrical device 1 is configured as a charger, when the first battery pack 2 or the second battery pack 3 engages with the electrical device 1, the electrical device 1 can charge the first battery pack 2 or the second battery pack 3.

The electrical device 1 includes a device housing 10, using FIG. 1 as an example, front-to-back, upper-to-lower, and left-to-right directions in the electrical device 1 are defined, a lengthwise extension direction of the device housing 10 in the state shown in FIG. 1 is defined as the upper-to-lower direction, and a width direction of the device housing 10 is defined as the left-to-right direction, the front-to-back direction is perpendicular to both the left-to-right direction and the upper-to-lower direction.

The electrical device 1 includes a battery pack mounting portion 100, the battery pack mounting portion 100 is arranged on the device housing 10 and configured to detachably engage with the first battery pack 2 or the second battery pack 3.

Optionally, the electrical device 1 includes two battery pack mounting portions 100 arranged oppositely in the front-to-back direction, the two battery pack mounting portions 100 are of the same structure, and each can be engaged with the first battery pack 2 or the second battery pack 3.

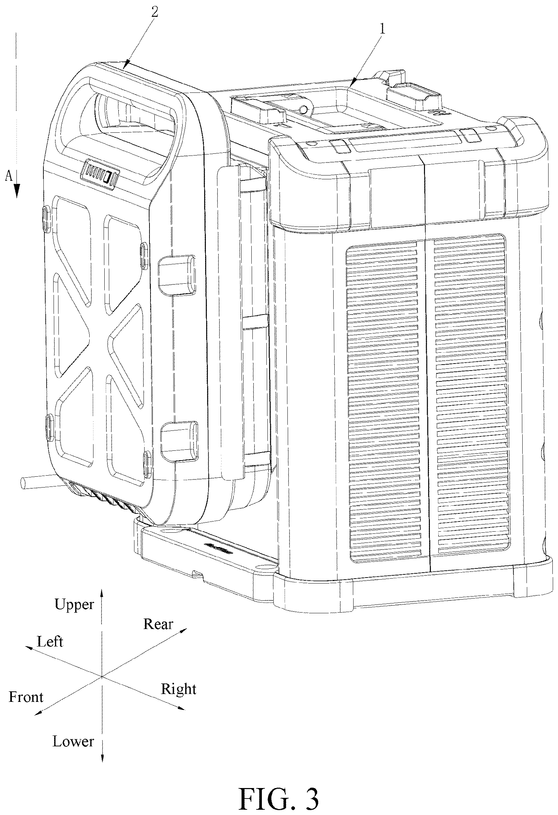

The battery pack mounting portion 100 includes a pair of first guiding portions 110a and 110b and a pair of second guiding portions 120a and 120b, the first guiding portions 110a and 110b are configured to guide the first battery pack 2 to engage with the electrical device 1 in an engaging direction A, the second guiding portions 120a and 120b are configured to guide the second battery pack 3 to engage with the electrical device 1 in the engaging direction A, the first guiding portions 110a and 110b and the second guiding portions 120a and 120b are independent of each other, and in a width direction perpendicular to the engaging direction A, the pair of first guiding portions 110a and 110b are located on two sides of the pair of second guiding portions 120a and 120b. In some embodiments, as shown in FIG. 3, the engaging direction A is set to be lower in the upper-to-lower direction, and the width direction is set to be the left-right direction.

It should be noted that "The first guiding portion and the second guiding portion are independent of each other" is understood as follows: A function of the first guiding portion and a function of the second guiding portion are independent of each other, in other words, a function of the first guiding portion for guiding the first battery pack 2 to engage with the electrical device 1 in the engaging direction A and a function of the second guiding portion for guiding the second battery pack 3 to engage with the electrical device 1 in the engaging direction A do not intersect each other.

In addition, "the pair of first guiding portions 110a and 110b are located on two sides of the pair of second guiding portions 120a and 120b" is understood as follows: One first guiding portion 110a of the pair of first guiding portions is located on an outer side of one second guiding portion 120a of the pair of second guiding portions, the other first guiding portion 110b of the pair of first guiding portions is located on an outer side of the other second guiding portion 120b of the pair of second guiding portions, and a spacing between the pair of first guiding portions 110a and 110b is greater than a spacing between the pair of second guiding portions 120a and 120b.

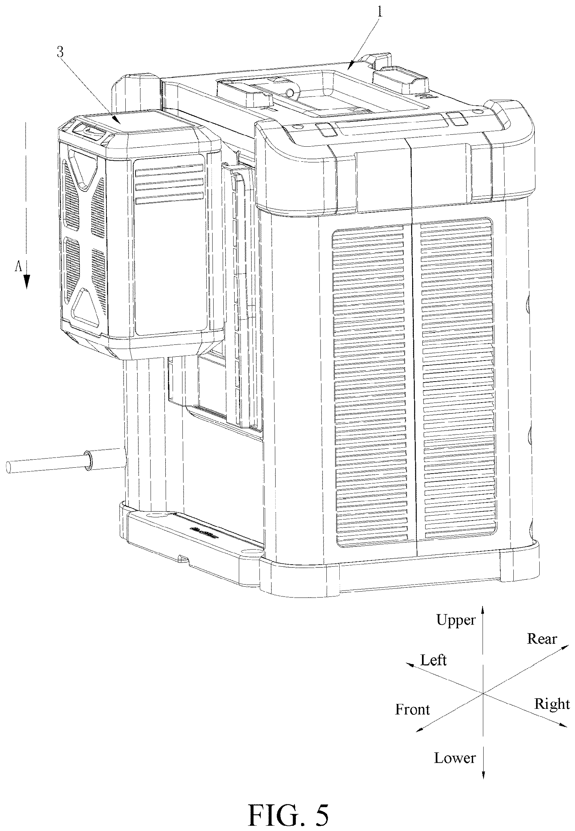

As shown in FIG. 3 and FIG. 5, the first battery pack 2 slides from top to bottom along the pair of first guiding portions 110a and 110b, so that the first battery pack 2 engages with the electrical device 1; and the second battery pack 3 slides from top to bottom along the pair of second guiding portions 120a and 120b, so that the second battery pack 3 engages with the electrical device 1. Similarly, the first battery pack 2 slides from bottom to top along the pair of first guiding portions 110a and 110b, so that the first battery pack 2 disengages from the electrical device 1; and the second battery pack 3 slides from bottom to top along the pair of second guiding portions 120a and 120b, so that the second battery pack 3 disengages from the electrical device 1.

The electrical device 1 can adapt to battery packs with two different interface sizes, to facilitate universality of the electrical device 1, and the size of the battery pack mounting portion 100 is reduced, to facilitate miniaturization of the electrical device 1.

Further, the pair of first guiding portions 110a and 110b are spaced apart from each other in the width direction, the pair of second guiding portions 120a and 120b are also spaced apart from each other in the width direction, and both the pair of first guiding portions 110a, 110b and the pair of second guiding portions 120a and 120b extend in the engaging direction A.

Optionally, the sizes of the pair of first guiding portions 110a and 110b in the engaging direction A are the same, and the sizes of the pair of second guiding portions 120a and 120b in the engaging direction A are the same.

Optionally, a center line of the pair of first guiding portions 110a and 110b coincides with a center line of the pair of second guiding portions 120a and 120b. Specifically, the pair of first guiding portions 110a and 110b and the pair of second guiding portions 120a and 120b are arranged symmetrically along a center line of the device housing 10.

Optionally, the pair of first guiding portions 110a and 110b and the pair of second guiding portions 120a and 120b at least partially overlap in the engaging direction A. In such an arrangement, the size of the battery pack mounting portion 100 can be reduced, to facilitate miniaturization of the electrical device 1.

Optionally, projection regions of the pair of second guiding portions 120a and 120b on a plane perpendicular to the width direction are located within projection regions of the pair of first guiding portions 110a and 110b on the plane perpendicular to the width direction.

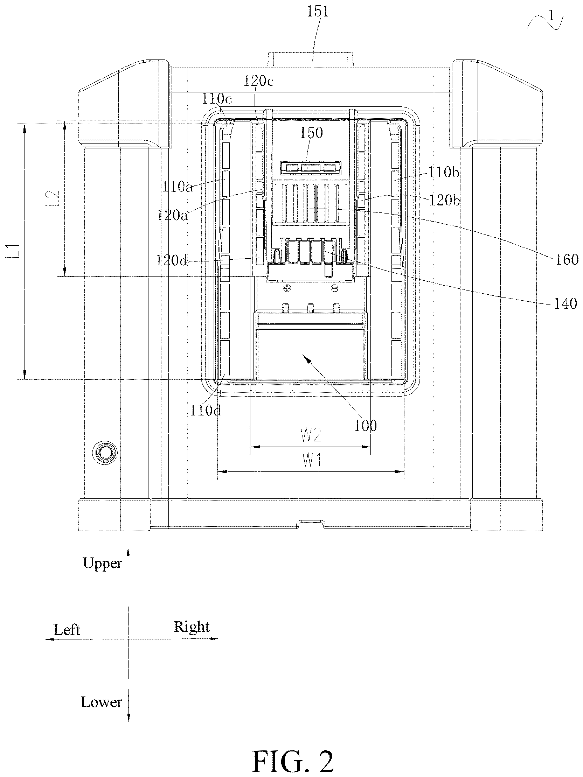

Optionally, as shown in FIG. 2, in the engaging direction A, the second guiding portions 120a and 120b do not exceed a region range defined by the first guiding portions 110a and 110b.

Optionally, in the engaging direction A, a ratio of a length L1 of the first guiding portions 110a and 110b to a length L2 of the second guiding portions 120a and 120b ranges from 1.5 to 2. In such an arrangement, the battery pack can be easily plugged into and unplugged from the electrical device while ensuring the structural strength of the guiding portions. Optionally, in the engaging direction, the length L1 of the first guiding portions 110a and 110b is 211 mm, and the length L2 of the second guiding portions 120a and 120b is 120 mm, in this case, the ratio of the length L1 of the first guiding portions 110a and 110b to the length L2 of the second guiding portions 120a and 120b is about 1.76.

Optionally, in the width direction, a ratio of a maximum distance W1 between the pair of first guiding portions 110a and 110b to a maximum distance W2 between the pair of second guiding portions 120a and 120b ranges from 1.5 to 2.5, in such an arrangement, the battery pack can be easily plugged into and unplugged from the electrical device while ensuring the structural strength of the guiding portions. Optionally, the maximum distance W1 between the pair of first guiding portions 110a and 110b is 135 mm, and the maximum distance W2 between the pair of second guiding portions 120a and 120b is 76 mm, in this case, the ratio range of the maximum distance W1 between the pair of first guiding portions 110a and 110b to the maximum distance W2 between the pair of second guiding portions 120a and 120b is about 1.78.

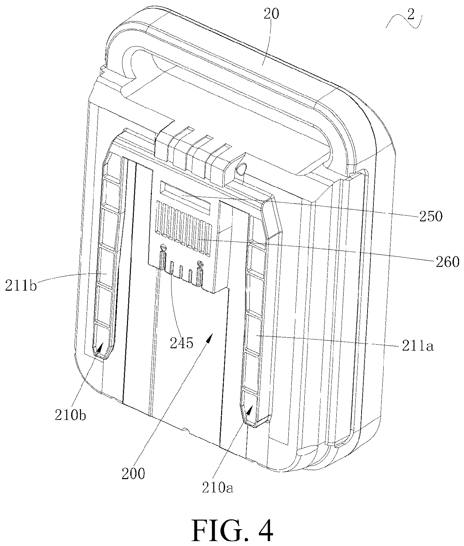

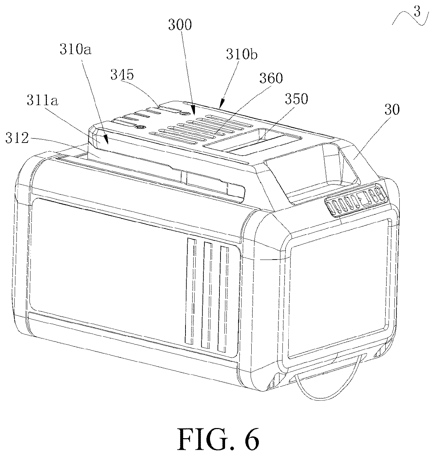

Correspondingly, as shown in FIG. 4, the first battery pack 2 includes a first housing 20, a first mounting portion 200 is arranged on the first housing 20, the first mounting portion 200 includes a pair of first engaging portions 210a and 210b, the pair of first engaging portions 210a and 210b are configured to engage with the pair of first guiding portions 110a and 110b respectively, to implement engaging between the electrical device 1 and the first battery pack 2. As shown in FIG. 6, the second battery pack 3 includes a second housing 30, a second mounting portion 300 is arranged on the second housing 30, the second mounting portion 300 includes a pair of second engaging portions 310a and 310b, the pair of second engaging portions 310a and 310b are configured to engage with the pair of second guiding portions 120a and 120b respectively, to implement engaging between the electrical device 1 and the second battery pack 3.

It should be noted that the first guiding portion, the second guiding portion, the first engaging portion, and the second engaging portion may also be other engaging forms. The first guiding portion, the second guiding portion, the first engaging portion, and the second engaging portion are not limited by feature shapes and sizes.

As shown in FIG. 2, in the engaging direction A, a size L2 of the second guiding portions 120a and 120b is less than a size L1 of the first guiding portions 110a and 110b, the first guiding portions 110a and 110b have an engaging beginning end 110c and an engaging tail end 110d that are oppositely arranged in the engaging direction A, the second guiding portions 120a and 120b have an engaging beginning end 120c and an engaging tail end 120d that are oppositely arranged in the engaging direction A, both the first battery pack 2 and the second battery pack 3 come, when engaging with the electrical device 1, into contact with the engaging beginning ends 110c and 120c earlier than the engaging tail ends 110d and 120d, and the engaging tail end 120d of the second guiding portion is closer to the engaging beginning end 110c of the first guiding portion than the engaging tail end 110d of the first guiding portion. In this way, the second battery pack 3 can engage with the electrical device 1 in place earlier than the first battery pack 2, thereby avoiding a case that the second battery pack 3 cannot be easily removed from the electrical device when a shell or another shelter is arranged outside an engaging region of the electrical device.

Under a specific voltage, when energy of the battery pack is larger, capacity of the battery pack is larger, a quantity of cells arranged in the battery pack is larger, a weight of the battery pack is larger, and a loading area required by the electrical device to be connected to the battery pack is larger. However, a loading area provided on the electrical device should not be excessively large. Otherwise, sizes of the electrical device and the battery pack become larger, which does not facilitate carrying and use for a user. It should be noted that the "loading area" is understood as an area of an engaging region defined by a pair of guiding portions, that is, an area of an engaging region obtained by multiplying a size of the pair of guiding portions in the engaging direction A by a maximum distance between the pair of guiding portions in the width direction.

In the present invention, a ratio of energy of the first battery pack 2 to an area of an engaging region defined by the pair of first guiding portions 110a and 110b is defined as a first energy loading ratio, a ratio of energy of the second battery pack 3 to an area of an engaging region defined by the pair of second guiding portions 120a and 120b is defined as a second energy loading ratio, the first energy loading ratio is in a range of 2.05 to 5.58 Wh/cm², and/or the second energy loading ratio is in a range of 1.20 to 7.20 Wh/cm².

The first energy loading ratio and the second energy loading ratio are set in this way, so that when the loading requirement of the battery pack mounting portion 100 for the battery pack is satisfied, the energy of the battery pack can become as large as possible, thereby satisfying the usage requirement of increasing single-pack capacity.

Optionally, the area of the engaging region defined by the first guiding portions 110a and 110b is 322.5 cm², the energy of the first battery pack 2 ranges from 600 to 1800 Wh, the area of the engaging region defined by the second guiding portions 120a and 120b is 100 cm², and the energy of the second battery pack 2 ranges from 120 to 720 Wh.

Optionally, the capacity of the first battery pack 2 is greater than the capacity of the second battery pack 3. Optionally, the capacity of the first battery pack 2 is 11 Ah, the capacity of the second battery pack 3 is 4 Ah, and rated voltages of the first battery pack 2 and the second battery pack 3 are both 60 V. The first battery pack 2 is configured to supply power to a power tool with a large volume and/or high power, such as a hand-push lawn mower or a blower, during use, the first battery pack 2 is directly mounted on the hand-push lawn mower, and the user does not need to directly burden the weight of the battery pack, or the first battery pack 2 is mounted on a back rack. The second battery pack 3 is configured to supply power to a handheld power tool, such as a grass trimmer or a branch trimmer, the second battery pack 3 is directly mounted on the handheld power tool, when using the handheld power tool, a worker does not need to supply power to the handheld power tool through a cable, making use more convenient.

Optionally, the weight of the first battery pack 2 is greater than the weight of the second battery pack 3. Optionally, a ratio of the weight of the first battery pack 2 to the weight of the second battery pack 3 ranges from 2 to 8. The weight of the first battery pack 2 ranges from 7.5 to 8.5 kg, and the weight of the second battery pack 3 ranges from 1.2 to 3.5 kg.

In some embodiments, as shown in FIG. 1, the pair of first guiding portions 110a and 110b are arranged back to back, and the pair of second guiding portions 120a and 120b are arranged face to face. Based on this arrangement, the pair of first guiding portions 110a and 110b are configured as a pair of outer slide rails, and the pair of second guiding portions 120a and 120b are configured as a pair of inner slide rails, correspondingly, as shown in FIG. 4 and FIG. 6, the pair of first engaging portions 210a and 210b are configured as a pair of inner slide rails, and the pair of second engaging portions 310a and 310b are configured as a pair of outer slide rails.

Certainly, a person skilled in the art may also arranges the pair of first guiding portions face to face, that is, as a pair of inner slide rails, and the pair of second guiding portions back to back, that is, as a pair of outer slide rails, correspondingly, the pair of first engaging portions are configured as a pair of outer slide rails, and the pair of second engaging portions are configured as a pair of inner slide rails; or the pair of first guiding portions and the pair of second guiding portions are each configured as a pair of outer slide rails, correspondingly, the pair of first engaging portions and the pair of second engaging portions are each configured as a pair of inner slide rails; or the pair of first guiding portions and the pair of second guiding portions are each configured as a pair of inner slide rails, correspondingly, the pair of first engaging portions and the pair of second engaging portions are each configured as a pair of outer slide rails.

Further, the battery pack mounting portion 100 further includes a first support portion 130 and a second support portion 131, the pair of first guiding portions 110a and 110b include a pair of first extension portions 111a and 111b that extend in the engaging direction A, the pair of second guiding portions 120a and 120b include a pair of second extension portions 121a and 121b that extend in the engaging direction A, the first extension portion 111a protrudes from an outer side of the first support portion 130 in the width direction, the first extension portion 111b protrudes from an outer side of the second support portion 131 in the width direction, the second extension portion 121a protrudes from an inner side of the first support portion 130 in the width direction, and the second extension portion 121b protrudes from an inner side of the second support portion 131 in the width direction.

In other words, one first extension portion 111a of the pair of first extension portions and one second extension portion 121a of the pair of second extension portions share the first support portion 130, and the other first extension portion 111b of the pair of first extension portions and 121b of the pair of second extension portions share the second support portion 131. In such an arrangement, the layout of the battery pack mounting portion 100 can be compact, thereby reducing the space occupied by the battery pack mounting portion 100, and therefore reducing the volume of the electrical device 1.

It should be noted that the outer sides of the first support portion 130 and the second support portion 131 refers to sides of the first support portion 130 and the second support portion 131 away from the center line of the pair of first guiding portions 110a and 110b and the center line of the pair of second guiding portions 120a and 120b, and the inner sides of the first support portion 130 and the second support portion 131 refers to sides of the first support portion 130 and the second support portion 131 close to the center line of the pair of first guiding portions and the center line of the pair of second guiding portions. In some embodiments, as shown in FIG. 1, the outer side refers to a left side, and the inner side refers to a right side.

Further, the first guiding portion 110a further includes an outer sidewall 132 of the first support portion 130, and the first guiding portion 110b further includes an outer sidewall 133 of the second support portion 131. Correspondingly, the first engaging portion includes an inner sidewall configured to engage with the first extension portion, and a first contact portion engaging with an outer sidewall of the first guiding portion, as shown in FIG. 4, using the first engaging portion 210a as an example, the first engaging portion 210a includes an inner sidewall (not shown) engaging with the first extension portion 111a, and a first contact portion 211a engaging with an outer sidewall 132. Therefore, when the first battery pack 2 slidably engages with the electrical device 1 in the engaging direction A, the first extension portion 111a, the outer sidewall 132, the second extension portion 111b, and the outer sidewall 133 jointly constitute guidance and restriction for the first battery pack 2.

Similarly, the second guiding portion 120a further includes an inner sidewall 134 of the first support portion 130, and the second guiding portion 120b further includes an inner sidewall 135 of the second support portion 131. Correspondingly, the second engaging portion includes an outer sidewall configured to engage with the second extension portion, and a second contact portion engaging with an inner sidewall of the second guiding portion, as shown in FIG. 6, using the second engaging portion 310a as an example, the second engaging portion 310a includes an outer sidewall 312 engaging with the second extension portion 121a, and a second contact portion 311a engaging with an inner sidewall 134. Therefore, when the second battery pack 3 slidably engages with the electrical device 1 in the engaging direction A, the second extension portion 121a, the inner sidewall 134, the second extension portion 121b, and the inner sidewall 135 jointly constitute guidance and restriction for the second battery pack 3.

In some embodiments, as shown in FIG. 1, the battery pack mounting portion 100 further includes a plurality of device terminals 140 located between the pair of second guiding portions 120a and 120b, and the device terminals 140 are evenly distributed in the width direction, correspondingly, the first battery pack 2 includes a plurality of first terminals (not shown) located between the first engaging portions 210a and 210b, and the second battery pack 3 includes a plurality of second terminals (not shown) located between the second engaging portions 310a and 310b. When the first battery pack 2 engages with the electrical device 1, a device terminal 140 is configured to be electrically connected to a corresponding first terminal, to implement power transmission between the first battery pack 2 and the electrical device 1; when the second battery pack 3 engages with the electrical device 1, a device terminal 140 is configured to be electrically connected to a corresponding second terminal, to implement power transmission between the second battery pack 3 and the electrical device 1.

It should be noted that the device terminal 140, the first terminal, and the second terminal could be arranged in any form readily conceivable to a person skilled in the art. Details are not described herein again in the present invention.

Both the first battery pack 2 and the second battery pack 3 can engage with the device terminal 140, and there is no need to arrange two types of device terminals, resulting in a simple and compact structure, to facilitate miniaturization of the electrical device.

Specifically, the device terminals 140 includes a positive device terminal and a negative device terminal, correspondingly, the first terminals include a first positive terminal and a first negative terminal, and the second terminals include a second positive terminal and a second negative terminal. When the first battery pack 2 engages with the electrical device 1, the positive device terminal is pluggably connected to the first positive terminal, and the negative device is pluggably connected to the first negative terminal, to implement power transmission between the first battery pack 2 and the electrical device 1. When the second battery pack 3 engages with the electrical device 1, the positive device terminal is pluggably connected to the second positive terminal, and the negative device terminal is pluggably connected to the second negative terminal, to implement power transmission between the second battery pack 3 and the electrical device 1.

Further, the device terminals 140 further include at least one signal device terminal 143, the first terminals further include at least one first signal terminal, and the second terminals further include at least one second signal terminal. When the first battery pack 2 engages with the electrical device 1, the signal device terminal is pluggably connected to the first signal terminal, to implement signal transfer between the first battery pack 2 and the electrical device 1. When the second battery pack 3 engages with the electrical device 1, the signal device terminal is pluggably connected to the second signal terminal, to implement signal transfer between the second battery pack 3 and the electrical device 1.

Optionally, a terminal socket 145 is arranged on the device housing 10, and the device terminal 140 is at least partially mounted on the terminal socket 145. Correspondingly, as shown in FIG. 4, the first housing 20 is provided with a plurality of first terminal slots 245 located between the pair of first engaging portions 210a and 210b, and each first terminal is at least partially received in one first terminal slot 245. As shown in FIG. 6, the second housing 30 is provided with a plurality of second terminal slots 345 located between the pair of second engaging portions 310a and 310b, and each second terminal is at least partially received in one second terminal slot 345.

In some embodiments, the battery pack mounting portion further includes a locking member 150 located between the pair of second guiding portions 120a and 120b, correspondingly, as shown in FIG. 4, the first mounting portion 200 includes a first locking portion 250 located between the pair of first engaging portions 210a and 210b, as shown in FIG. 6, the second mounting portion 300 includes a second locking portion 350 located between the pair of second engaging portions 310a and 310b. When the first battery pack 2 engages with the electrical device 1, the locking member 150 is configured to engage with the first locking portion 250, to lock the first battery pack 2 to the electrical device 1; when the second battery pack 3 engages with the electrical device 1, the locking member 150 is configured to engage with the second locking portion 350, to lock the second battery pack 3 to the electrical device 1.

When engaging with the electrical device 1, the first battery pack 2 and the second battery pack 3 can share the locking member 150, resulting in a simple and compact structure, to facilitate miniaturization of the electrical device.

Optionally, the locking member 150 is configured as a snap, and the first locking portion 250 and the second locking portion 350 are configured as slots that engage with the snap.

Further, the electrical device 1 further includes a triggering member 151. The triggering member 151 can drive the locking member 150 to move from a locked position to an unlocked position, when the locking member 150 is in the locked position, the locking member 150 engages with the first locking portion 250 or the second locking portion 350, to lock the electrical device 1 to the first battery pack 2 or the second battery pack 3; when the locking member 150 is in the unlocked position, the locking member 150 disengages from engaging with the first locking portion 250 or the second locking portion 350, to unlock the electrical device 1 from the first battery pack 2 or the second battery pack 3. Optionally, the triggering member 151 is configured as a button.

It should be noted that the locking member 150, the first locking portion 250, and the second locking portion 350 may be configured in other forms. For example, the locking member 150 is configured as a slot, and the first locking portion 250 and the second locking portion 350 are configured as snaps that engage with the slot. This is not limited in the present invention.

In some embodiments, the electrical device 1 further includes a device air vent 160 located between the pair of second guiding portions 120a and 120b, When the first battery pack 2 engages with the electrical device 1, air flow can flow into and/or out from the device air vent 160, to cool the first battery pack 2 and/or the electrical device 1; when the second battery pack 3 engages with the electrical device 1, air flow can flow into and/or out from the device air vent 160, to cool the second battery pack 3 and/or the electrical device 1. Optionally, in the engaging direction A, the air vent 160 is arranged between the locking member 150 and the device terminal 140.

Correspondingly, as shown in FIG. 4, the first battery pack 2 further includes a first air vent 260 located between the pair of first engaging portions 210a and 210b, when the first battery pack 2 engages with the electrical device 1, the first air vent 260 is at least partially aligned with the device air vent 160, to implement air flow conduction between the first battery pack 2 and the electrical device 1. As shown in FIG. 6, the second battery pack 3 further includes a second air vent 360 located between the pair of second engaging portions 310a and 310b, when the second battery pack 3 engages with the electrical device 1, the second air vent 360 is at least partially aligned with the device air vent 160, to implement air flow conduction between the second battery pack 3 and the electrical device 1.

Further, the electrical device 1 further includes a fan (not shown) arranged in the device housing 10.

In some embodiments, the fan is configured as a suction fan, the device air vent 160 is configured as an air inlet of the electrical device 1, the first air vent 260 is configured as an air outlet of the first battery pack 2, and the second air vent 360 is configured as an air outlet of the second battery pack 3. When the electrical device 1 engages with the first battery pack 2 or the second battery pack 3, cooling air can flow out of the first battery pack 2 or the second battery pack 3 from the first air vent 260 or the second air vent 360, after cooling the first battery pack 2 or the second battery pack 3, and then enter the device housing 10 through the device air vent 160, to cool heat-generating electronic devices in the electrical device 1.

In some embodiments, the fan is configured as a blowing fan, the device air vent 160 is configured as an air outlet of the electrical device 1, the first air vent 260 is configured as an air inlet of the first battery pack 2, and the second air vent 360 is configured as an air inlet of the second battery pack 3. When the electrical device 1 engages with the first battery pack 2 or the second battery pack 3, cooling air can flow in from an air inlet (not shown) on the electrical device 1, after cooling heat-generating electronic devices in the electrical device 1, then flow out from the device air vent 160, and finally enter the first battery pack 2 or the second battery pack 3 from the first air vent 260 or the second air vent 360, to cool the first battery pack 2 or the second battery pack 3.

In some embodiments, the electrical device 1 does not include a fan, and is cooled by using natural wind. The cooling air can flow in from the device air vent 160 and flow out from the device air vent 160, to cool heat-generating electronic devices in the electrical device 1.

When engaging with the electrical device 1, the first battery pack 2 and the second battery pack 3 can share the device air vent 160, resulting in a simple and compact structure, to facilitate miniaturization of the electrical device.

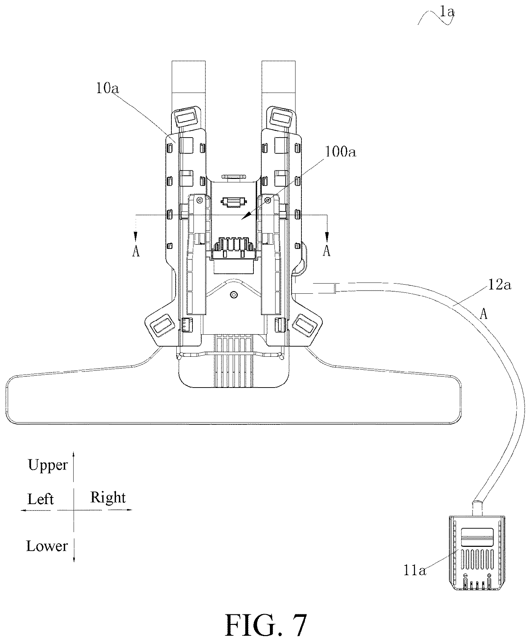

In some embodiments, as shown in FIG. 7, an electrical device 1a may also configured as a back-carrying apparatus for a user to carry on the back. The electrical device 1a includes a battery pack mounting portion 100a arranged on a device housing 10a, the battery pack mounting portion 100a is configured to engage with a first battery pack 2 or a second battery pack 3. The electrical device 1a further includes an adapter 11a, the adapter 11a is configured to engage with a power tool, the adapter 11a is electrically connected to the battery pack mounting portion 100a through a cable 12a. When the first battery pack 2 or the second battery pack 3 engages with the electrical device 1a, and the adapter 11a engages with the power tool, the first battery pack 2 or the second battery pack 3 can transfer power to the power tool.

The structure of the battery pack mounting portion 100a is the same as that of the foregoing battery pack mounting portion 100. Details are not described herein again in the present invention.

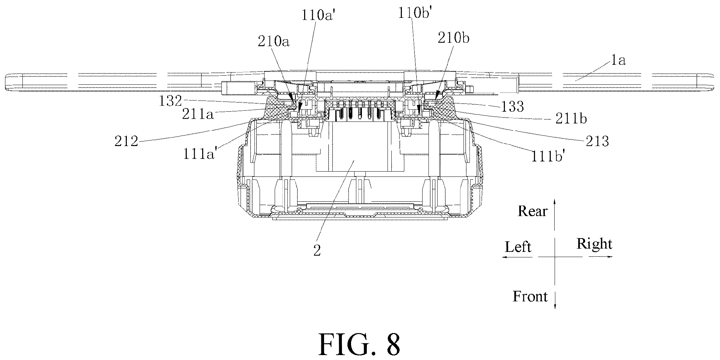

As shown in FIG. 8, a first battery pack 2 engages with an electrical device 1a, in a width direction, a maximum distance between a pair of first guiding portions 110a' and 110b' is substantially the same as a maximum distance between a pair of first engaging portions 210a and 210b. The first guiding portion 110a' engages with the first engaging portion 210a, the first guiding portion 110b' engages with the first engaging portion 210b, specifically, a first extension portion 111a' engages with an inner sidewall 212 of the first battery pack 2, a first extension portion 111b' engages with an inner sidewall 213 of the first battery pack, an outer sidewall 132 of the first guiding portion 110a' engages with a first contact portion 211a, and an outer sidewall 133 of the first guiding portion 110b' engages with a first contact portion 211b, so the first battery pack 2 can be slidably mounted on the electrical device 1a in an engaging direction A.

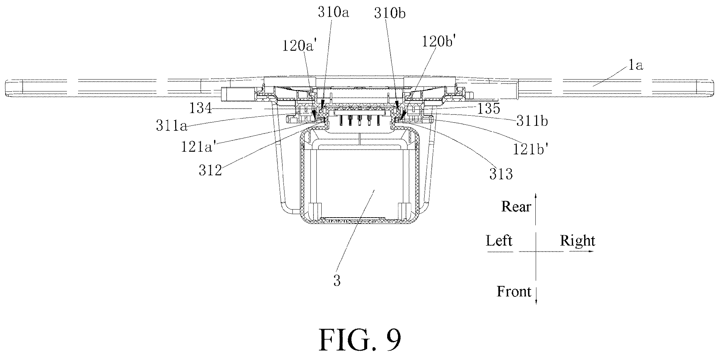

As shown in FIG. 9, a second battery pack 3 engages with an electrical device 1a, in a width direction, a maximum distance between a pair of second guiding portions 120a' and 120b' is substantially the same as a maximum distance between a pair of second engaging portions 310a and 310b. The second guiding portion 120a' engages with the second engaging portion 310a, the second guiding portion 120b' engages with the second engaging portion 310b, specifically, a second extension portion 121a' engages with an outer sidewall 312 of the second battery pack 3, a second extension portion 121b' engages with an outer sidewall 313 of the second battery pack 3, an inner sidewall 134 of the second guiding portion 120a' engages with a second contact portion 311a of the second battery pack, and an inner sidewall 135 of the second guiding portion 120b' engages with a second contact portion 311b, so the second battery pack 3 can be slidably mounted on the electrical device 1a in an engaging direction A.

According to the back-carrying apparatus provided by the present invention, the first guiding portion and the second guiding portion are arranged at the battery pack mounting portion, so that not only two types of battery packs can be mounted, but also space of the back-carrying apparatus can be saved.

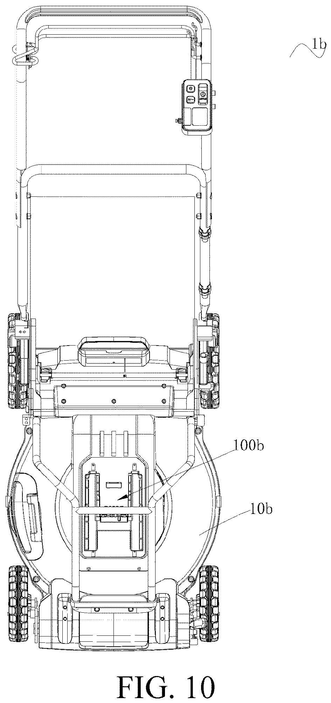

In some embodiments, the electrical device could also be configured as a power tool or a household appliance. The power tool could be configured as a lawn mower, a grass trimmer, a blower, or the like. The household appliance could be configured as an electric fan, a vacuum cleaner, or the like. As shown in FIG. 10, an electrical device 1b could be configured as a lawn mower. The electrical device 1b includes a battery pack mounting portion 100b arranged on a device housing 10b. The battery pack mounting portion 100b is configured to engage with a first battery pack 2 or a second battery pack 3. When the first battery pack 2 or the second battery pack 3 engages with the electrical device 1b, the first battery pack 2 or the second battery pack 3 can provide power to the electrical device 1b.

Similarly, the structure of the battery pack mounting portion 100b is the same as that of the foregoing battery pack mounting portion 100. Details are not described herein again in the present invention.

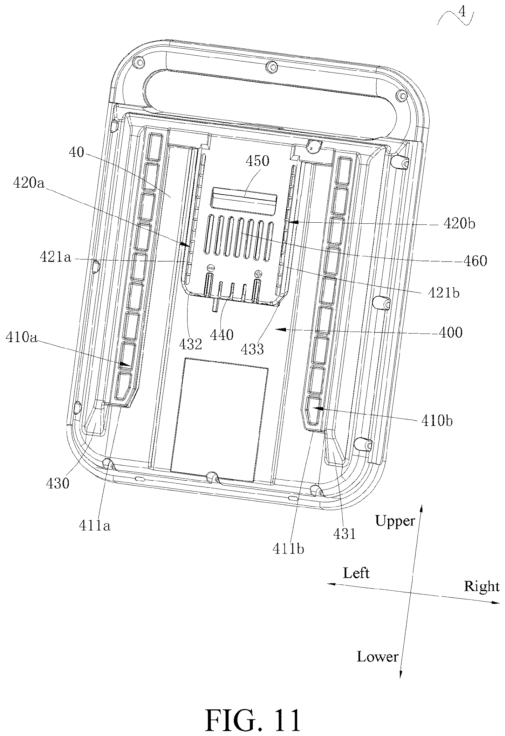

As shown in FIG. 11, some embodiments of the present invention further provide a battery pack 4. The battery pack 4 includes a battery pack housing 40, an electrical device mounting portion 400 is arranged on the battery pack housing 40, and the electrical device mounting portion 400 is configured to detachably engage with a first electrical device or a second electrical device.

The electrical device mounting portion 400 includes a pair of first leading portions 410a and 410b and a pair of second leading portions 420a and 420b, the first leading portions 410a and 410b are configured to guide the battery pack 4 to engage with the first electrical device (not shown) in an engaging direction B, the second leading portions 420a and 420b are configured to guide the battery pack 4 to engage with the second electrical device (not shown) in the engaging direction B, the first leading portions 410a and 410b and the second leading portions 420a and 420b are independent of each other, and in a width direction perpendicular to the engaging direction B, the pair of first leading portions 410a and 410b are located on two sides of the pair of second leading portions 420a and 420b.

The battery pack 4 can adapt to electrical devices with two different interface sizes, to facilitate universality of the battery pack 4., and projection regions of the two types of guiding portions on a plane perpendicular to the width direction at least partially overlap, to reduce the size of the electrical device mounting portion 400 and facilitate miniaturization of the battery pack 4.

The structure of the electrical device mounting portion 400 is substantially the same as that of the foregoing battery pack mounting portion 100. For ease of description, the same structure of the battery pack 3 as that of the battery pack 1 is not repeated. Different structures are discussed in detail below.

In some embodiments, as shown in FIG. 11, a pair of first leading portions 410a and 410b are arranged face to face, and a pair of second leading portions 420a and 420b are arranged back to back. Based on the foregoing arrangement, the pair of first leading portions 410a and 410b are configured as inner slide rails, and the pair of second leading portions 420a and 420b are configured as outer slide rails, correspondingly, a pair of outer slide rails are arranged on the first electrical device, and a pair of inner slide rails are arranged on the second electrical device. Certainly, referring to the description of the foregoing battery pack mounting portion 100, the arrangement of the first leading portion and the second leading portion could also be other forms. Details are not described herein again.

Further, the electrical device mounting portion 400 further includes a first connection portion 430, a second connection portion 431, a third connection portion 432, and a fourth connection portion 433. The pair of first leading portions 410a and 410b respectively include a pair of first projection portions 411a and 411b extending in an engaging direction A, the pair of second leading portions 420a and 420b respectively include a pair of second projection portions 421a and 421b extending in the engaging direction A, the first projection portion 411a protrudes from an inner side of the first connection portion 430 in the width direction, the first projection portion 411b protrudes from an inner side of the second connection portion 431 in the width direction, the second projection portion 421a protrudes from an outer side of the third connection portion 432 in the width direction, the second projection portion 421b protrudes from an outer side of the fourth connection portion 433 in the width direction.

Likewise, similar to the foregoing battery pack mounting portion 100, the electrical device mounting portion 400 also includes a plurality of battery pack terminals 440 that are located between the pair of first leading portions 410a and 410b, a locking portion 450, and a battery pack air vent 460. For specific arrangements and structural forms of these components, reference is made to the foregoing part. Details are not described herein again. In such an arrangement, the first electrical device and the second electrical device can share these components, so that the structure is simple and compact, thereby miniaturizing the battery pack.

The technical features in the foregoing embodiments may be randomly combined. For concise description, not all possible combinations of the technical features in the embodiment are described. However, provided that combinations of the technical features do not conflict with each other, the combinations of the technical features are considered as falling within the scope recorded in this specification.

The foregoing embodiments only describe several implementations of the present invention, and their description is specific and detailed, but cannot therefore be understood as a limitation to the patent scope of the present invention. It should be noted that for a person of ordinary skill in the art, several transformations and improvements can be made without departing from the idea of the present invention. These transformations and improvements belong to the protection scope of the present invention. Therefore, the protection scope of the patent of the present invention shall be subject to the appended claims.

## Claims

1. An electrical device, comprising:
a device housing; and
a battery pack mounting portion, arranged on the device housing and configured to detachably engage with a first battery pack or a second battery pack, wherein the battery pack mounting portion comprises a pair of first guiding portions and a pair of second guiding portions, the first guiding portions are configured to guide the first battery pack to engage with the electrical device in an engaging direction, the second guiding portions are configured to guide the second battery pack to engage with the electrical device in the engaging direction, the first guiding portions and the second guiding portions are independent of each other, and in a width direction perpendicular to the engaging direction, the pair of first guiding portions are located on two sides of the pair of second guiding portions.

2. The electrical device according to claim 1, wherein the first guiding portion and the second guiding portion at least partially overlap in the engaging direction.

3. The electrical device according to claim 2, wherein in the engaging direction, the second guiding portion does not exceed a region range defined by the first guiding portion.

4. The electrical device according to claim 2, wherein in the engaging direction, a ratio of a length of the first guiding portion to a length of the second guiding portion ranges from 1.5 to 2.

5. The electrical device according to claim 2, wherein in the width direction, a ratio of a maximum distance between the pair of first guiding portions to a maximum distance between the pair of second guiding portions ranges from 1.5 to 2.5.

6. The electrical device according to claim 1, wherein the pair of first guiding portions are arranged back to back, and the pair of second guiding portions are arranged face to face.

7. The electrical device according to claim 6, wherein the battery pack mounting portion further comprises a first support portion and a second support portion that extend in the engaging direction, the pair of first guiding portions comprise a pair of first extension portions that extend in the engaging direction, the pair of second guiding portions comprise a pair of second extension portions that extend in the engaging direction, the pair of first extension portions respectively protrude from outer sides of the first support portion and the second support portion in the width direction, and the pair of second extension portions respectively protrude from inner sides of the first support portion and the second support portion in the width direction.

8. The electrical device according to claim 1, wherein a ratio of energy of the first battery pack to an area of an engaging region defined by the pair of first guiding portions is defined as a first energy loading ratio, a ratio of energy of the second battery pack to an area of an engaging region defined by the pair of second guiding portions is defined as a second energy loading ratio, the first energy loading ratio is in a range of 2.05 to 5.58 Wh/cm², and/or the second energy loading ratio is in a range of 1.20 to 7.20 Wh/cm².

9. The electrical device according to claim 1, wherein in the engaging direction, a size of the second guiding portion is less than a size of the first guiding portion, each of the first guiding portion and the second guiding portion has an engaging beginning end and an engaging tail end that are oppositely arranged in the engaging direction, both the first battery pack and the second battery pack come, when engaging with the electrical device, into contact with the engaging beginning end earlier than the engaging tail end, and the engaging tail end of the second guiding portion is closer to the engaging beginning end of the first guiding portion than the engaging tail end of the first guiding portion.

10. The electrical device according to any one of claims 1 to 9, wherein the battery pack mounting portion further comprises a plurality of device terminals located between the pair of second guiding portions, and the device terminals comprise a positive device terminal and a negative device terminal; when the first battery pack engages with the electrical device, the positive device terminal and the negative device terminal are configured to be electrically connected to corresponding terminals of the first battery pack, to implement power transmission between the first battery pack and the electrical device; and when the second battery pack engages with the electrical device, the positive device terminal and the negative device terminal are configured to be electrically connected to corresponding terminals of the second battery pack, to implement power transmission between the second battery pack and the electrical device.

11. The electrical device according to any one of claims 1 to 9, wherein the battery pack mounting portion further comprises a locking member located between the pair of second guiding portions, and when the first battery pack engages with the electrical device, the locking member is configured to engage with a corresponding locking portion of the first battery pack, to lock the first battery pack to the electrical device; and when the second battery pack engages with the electrical device, the locking member is configured to engage with a corresponding locking portion of the second battery pack, to lock the second battery pack to the electrical device.

12. The electrical device according to any one of claims 1 to 9, wherein the electrical device further comprises a device air vent located between the pair of second guiding portions, and when the first battery pack engages with the electrical device, air flow is flowable into and/or out from the device air vent, to cool the first battery pack and/or the electrical device; and when the second battery pack engages with the electrical device, air flow is flowable into and/or out from the device air vent, to cool the second battery pack and/or the electrical device.

13. The electrical device according to any one of claims 1 to 9, wherein the electrical device is configured as any one of a charger, a back-carrying apparatus, a power tool, and a household appliance.

14. An electrical system, comprising the electrical device according to any one of claims 1 to 13, the first battery pack, and the second battery pack.

15. A battery pack, comprising:
a battery pack housing; and
an electrical device mounting portion, arranged on the battery pack housing, and configured to detachably engage with a first electrical device or a second electrical device, wherein the electrical device mounting portion comprises a pair of first leading portions and a pair of second leading portions, the first leading portions are configured to guide the battery pack to engage with the first electrical device in an engaging direction, the second leading portions are configured to guide the battery pack to engage with the second electrical device in the engaging direction, the first leading portions and the second leading portions are independent of each other, and in a width direction perpendicular to the engaging direction, the pair of first leading portions are located on two sides of the pair of second leading portions.
